# EUROPÄISCHE PATENTSCHRIFT

(11) **EP 1 169 893 B1**
(45) Veröffentlichungstag und Bekanntmachung des Hinweises auf die Patenterteilung: **27.11.2002**
(21) Anmeldenummer: 00925047.3
(22) Anmeldetag: 16.03.2000
(51) Int. Cl.: H05K 3/00, H05K 3/06, H05K 3/42

(54) **VERFAHREN ZUM EINBRINGEN VON DURCHKONTAKTIERUNGSLÖCHERN IN EIN BEIDSEITIG MIT METALLSCHICHTEN VERSEHENES, ELEKTRISCH ISOLIERENDES BASISMATERIAL**
METHOD FOR INTRODUCING PLATED-THROUGH HOLES IN AN ELECTRICALLY INSULATING BASE MATERIAL THAT IS PROVIDED WITH METAL LAYERS ON BOTH SIDES
PROCEDE POUR INTRODUIRE DES TROUS DE CONNEXION TRANSVERSALE DANS UN MATERIAU DE BASE ELECTRO-ISOLANT MUNI DE PART ET D'AUTRE DE COUCHES DE METAL

(30) Priorität: 16.03.1999 DE 19911721
(43) Veröffentlichungstag der Anmeldung: 09.01.2002
(73) Patentinhaber: SIEMENS AKTIENGESELLSCHAFT, 80333 München (DE)
(72) Erfinder: HEERMAN, Marcel, B-9200 Merelbeke (BE)
(86) Internationale Anmeldenummer: DE0000813
(87) Internationale Veröffentlichungsnummer: WO00056129

(56) Entgegenhaltungen:
- EP-A- 0 062 300
- EP-A- 0 164 564
- EP-A- 0 361 192
- CH-A- 681 758
- DE-A- 3 732 249
- US-A- 3 265 546

## Beschreibung

Aus der EP-A-00 62 300 ist ein Verfahren zur Herstellung von Leiterplatten bekannt, bei welchem von einem beidseitig kupferkaschierten Basismaterial ausgegangen wird. Nach dem mechanischen Bohren von Durchgangslöchern wird durch chemische und nachfolgende galvanische Metallabscheidung eine Verkupferungsschicht auf die Lochwandungen und die Kupferkaschierungen aufgebracht. Nach dem anschließenden, ganzflächigen Aufbringen einer Ätzresistschicht wird diese dann mit Hilfe eines Laserstrahls selektiv wieder entfernt, so dass das gewünschte Leiterbahnmuster durch Abätzen der derart freigelegten Kupferschicht strukturiert werden kann.

Bei einem ähnlichen, aus der EP-A-0 361 192 bekannten Verfahren wird die Ätzresistschicht mit Hilfe eines Laserstrahls zunächst nur in den ummittelbar an das spätere Leiterbahnmuster angrenzenden Bereichen entfernt, worauf die dadurch freigelegten Bereich der Kupferschicht abgeätzt werden. In den noch verbleibenden, nicht dem Leiterbahnmuster entsprechenden unerwünschten Bereichen der Kupferschicht wird das Ätzresist elektrolytisch abgetragen, worauf diese unerwünschten Bereiche durch Ätzen entfernt werden.

Bei einem aus der US-A-3 265 546 bekannten Verfahren zur Herstellung von Leiterplatten wird zunächst das Lochmuster der späteren Durchkontaktierungslöcher mittels Phototechnik auf die Kupferkaschierungen übertragen und durch nachfolgendes Ätzen in die Kupferkaschierungen eingebracht. Das im Lochbereich der Kupferkaschierungen freiliegende Basismaterial wird dann zur Fertigstellung der Durchkontaktierungslöcher durch chemisches Ätzen abgetragen.

Bei einem ähnlichen, aus der EP-A-01 64 564 bekannten Verfahren zur Herstellung von Leiterplatten oder von Zwischenlaminaten für Mehrlagen-Leiterplatten wird das Lochmuster der späteren Durchkontaktierungslöcher ebenfalls mittels Phototechnik und anschließendes Ätzen in eine Kupferkaschierung eingebracht. Unter Verwendung der derart strukturierten Kupferkaschierung als Maske wird dann das ungeschützte Basismaterial mit Hilfe eines Laserstrahls abgetragen, wobei die gegenüberliegende Kupferkaschierung diesen Abtragungsprozess beendet.

Auch bei einem weiteren aus der CH-A-681758 bekannten Verfahren zum Herstellen von Leiterplatten oder von Zwischenlaminaten von Mehrlagen-Leiterplatten wird das Lochmuster der späteren Durchkontaktierungslöcher wieder mittels Phototechnik und anschließendes Ätzen in eine Kupferkaschierung oder in beide Kupferkaschierungen eingebracht. Unter Verwendung der derart strukturierten Kupferkaschierungen als ätzresistente Lochmasken werden dann die Durchkontaktierungslöcher durch Plasmaätzen in das Basismaterial eingebracht.

Es ist auch bereits bekannt, das Lochmuster der späteren Durchkontaktierungslöcher mittels Laserbohren in eine Metallschicht oder in beide Metallschichten eines beidseitig kupferkaschierten Basismaterials einzubringen. Die Lochmuster mit Durchmessern im Mikrometerbereich werden hierbei mit Hilfe von UV-Lasern oder IR-Lasern erzeugt. Der Bohrvorgang ist ein sequentieller Prozess und daher auch mit einem relativ hohen Zeitaufwand verbunden. Außerdem muss beim Laserbohren das Kupfer im Bereich der Löcher kreisförmig oder spiralförmig in mehreren Lagen abgetragen werden. Beim Laserbohren von Löchern mit einem Durchmesser von 150 µm oder 100 µm kann pro Durchgang abhängig von der verwendeten Laserart mit einem Abtrag von maximal 5 µm Kupfer gerechnet werden. Dieser Abtrag ist auch dadurch limitiert, dass während des Abtragens ein Plasma über dem Abtragungsort entsteht, welches die weitere Einbringung von Laserenergie verhindert. Außerdem kann der letzte Abtragungsschritt nicht mit der gleichen Leistung erfolgen, da die Haftung des darunterliegenden organischen Basismaterials am Rand des Loches sonst reduziert werden könnte. Bei einer Kupferschichtdicke von zum Beispiel 17 µm erfolgt die Einbringung der Löcher in vier bis fünf Abarbeitungslagen.

Der Erfindung liegt die Aufgabe zugrunde, bei einem Verfahren zum Einbringen von Durchkontaktierungslöchern in ein beidseitig mit Metallschichten versehenes, elektrisch isolierendes Basismaterial die Erzeugung der Lochmuster in einer Metallschicht oder in beiden Metallschichten rasch und mit geringem Aufwand vorzunehmen.

Die Lösung dieser Aufgabe erfolgt durch folgende Verfahrensschritte:
a) auf mindestens eine Metallschicht wird eine Ätzresistschicht aufgebracht;
b) die Ätzresistschicht wird im Bereich der späteren Durchkontaktierungslöcher mit elektromagnetischer Strahlung wieder entfernt;
c) die im Schritt b) freigelegten Bereiche der Metallschicht werden bis zur Oberfläche des Basismaterials weggeätzt;
d) die Durchkontaktierungslöcher werden mit Hilfe eines Laserstrahls in das Basismaterial eingebracht, wobei die in den Verfahrensschritten a) bis c) strukturierte Metallschicht als Marke für den Laserstrahl wirkt.

Bei dem erfindungsgemäßen Verfahren wird also in Anlehnung an die aus der EP-A-00 62 300 zur Herstellung von Leiterbahnmustern bekannte Vorgehensweise die Erzeugung der Lochmuster durch Strukturierung eines Ätzresists mittels elektromagnetischer Strahlung und nachfolgendes Ätzen bewirkt. Die dünne Ätzresistschicht wird dabei im Bereich der späteren Durchkontaktierungslöchern durch die elektromagnetische Strahlung mit hoher Geschwindigkeit kreisförmig oder spiralförmig abgetragen. Beim nachfolgenden selektiven Ätzprozess werden dann alle Löcher des Lochmusters gleichzeitig erzeugt, was gegenüber einem sequentiellen Bohrvorgang zu einer erheblichen Zeiteinsparung führt. Die Durchkontaktierungslöcher werden mit Hilfe eines Laserstrahls in das Basismaterial eingebracht, wodurch Unterätzungen der Metallschicht vollständig verhindert werden.

Vorteilhafte Ausgestaltungen des erfindungsgemäßen Verfahrens gehen aus den Unteransprüchen hervor.

Bei der Ausgestaltung nach Anspruch 2 wird die nicht mehr benötigte Ätzresistschicht nach dem Ätzvorgang vollständig entfernt. Das mit den Durchkontaktierungslöchern versehene Basismaterial kann dann zur Fertigstellung der Leiterplatten oder zur Fertigstellung von Zwischenlaminaten unter Verwendung der zuvor eingesetzten Lasereinrichtung nach dem aus der EP-A-00 62 300 bekannten Verfahren weiter behandelt werden. Die Erzeugung der auf das Basismaterial aufgebrachten Metallschichten kann beispielsweise durch chemische und nachfolgende galvanische Metallabscheidung oder durch Aufsputtern vorgenommen werden. Gemäß Anspruch 3 wird jedoch vorzugsweise von einem beidseitig kupferkaschierten Basismaterial ausgegangen, das mit geringem Aufwand hergestellt werden kann und das sich in der Leiterplattentechnik schon sehr lange Zeit bewährt hat.

Bei Verwendung von metallischen Ätzresistschichten gemäß Anspruch 4 führt deren Strukturierung mittels elektromagnetischer Strahlung zu sehr guten Ergebnissen.

Dabei hat es sich als besonders günstig erwiesen, wenn für die Ätzresistschicht gemäß Anspruch 5 Zinn oder eine Zinn-Blei-Legierung verwendet wird. Derartige Ätzresistschichten lassen sich einerseits beispielsweise mit einem Laser leicht strukturieren, während sie andererseits beim Ätzen einen sicheren Schutz der darunterliegenden Metallschicht gewährleisten.

Die metallische Ätzresistschicht wird gemäß Anspruch 6 vorzugsweise durch stromlose Metallabscheidung aufgebracht, da dies auf besonders wirtschaftliche Weise durchgeführt werden kann.

Für die Ätzresistschicht kann gemäß Anspruch 7 aber auch ein organisches Material verwendet werden. Das Aufbringen derartiger organischer Ätzresistschichten kann dann auf besonders einfache Weise gemäß Anspruch 8 durch Elektrotauchlackierung oder durch elektrostatische Beschichtung vorgenommen werden. Gemäß Anspruch 9 wird die elektromagnetische Strahlung vorzugsweise durch einen Laser erzeugt, da Laserstrahlen für einen Abtrag bzw. für ein Verdampfen der Ätzresistschicht in den erwünschten Bereichen besonders geeignet sind. Die Bewegung des Laserstrahls relativ zum Basismaterial sollte dann gemäß Anspruch 10 vorzugsweise frei programmierbar sein, das heißt, dass eine Konturbeschreibung des Lochmusters mit dem Laserstrahl rasch durchgeführt und insbesondere auch leicht variiert werden kann.

Die Ausgestaltung nach Anspruch 11 sieht vor, dass die Durchkontaktierungslöcher als durch eine Metallschicht begrenzte Sacklöcher in das Basismaterial eingebracht werden. Eine derartige Vorgehensweise ist sowohl für die Herstellung von Leiterplatten als auch für die Herstellung von Zwischenlaminaten für Mehrlagen-Leiterplatten geeignet.

Gemäß Anspruch 12 ist es aber auch möglich, die Durchkontaktierungslöcher als Durchgangslöcher in das Basismaterial einzubringen. Bei dieser Variante müssen dann allerdings beide Metallschichten mit dem entsprechenden Lochmuster der Durchkontaktierungslöcher versehen werden.

Ausführungsbeispiele der Erfindung sind in der Zeichnung dargestellt und werden im folgenden näher beschrieben.

Es zeigen
- Figur 1 bis Figur 6: in stark vereinfachter schematischer Darstellung verschiedene Verfahrensstadien beim Einbringen von Sacklöchern in ein beidseitig mit Metallschichten versehenes Basismaterial und
- Figur 7 bis Figur 12: in stark vereinfachter schematischer Darstellung verschiedene Verfahrensstadien beim Einbringen von Durchgangslöchern in ein beidseitig mit Metallschichten versehenes Basismaterial.

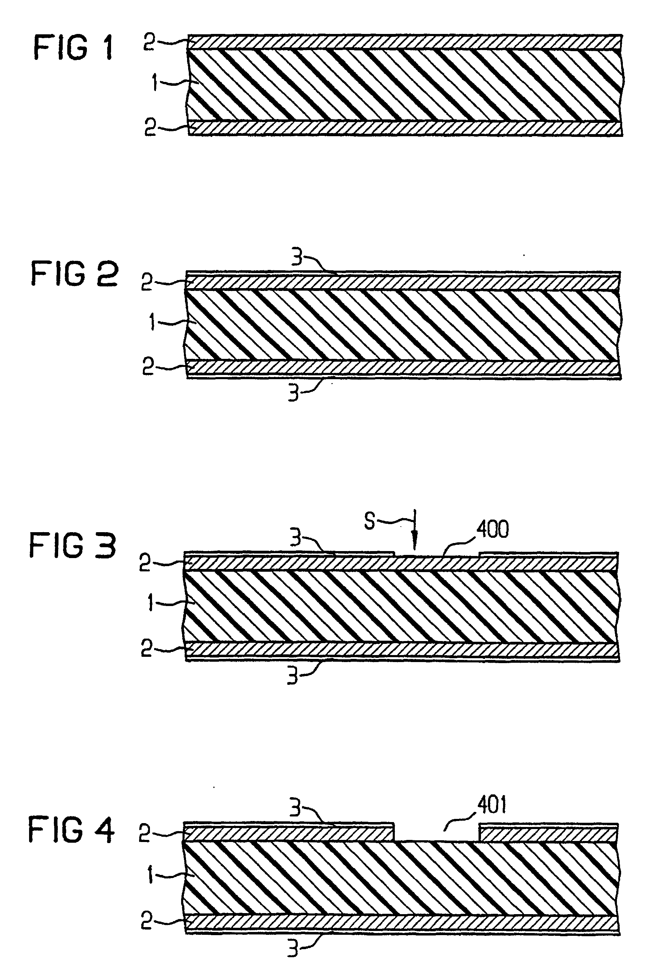

Gemäß Figur 1 wird von einem elektrisch isolierenden Basismaterial 1 ausgegangen, welches beidseitig mit Metallschichten 2 versehen ist. Im dargestellten Ausführungsbeispiel handelt es sich bei den Metallschichten 2 um Kupferkaschierungen, die beispielsweise eine Stärke von 10 µm aufweisen.

Gemäß Figur 2 wird auf die Metallschichten 2 eine Ätzresistschicht 3 aufgebracht. Im geschilderten Ausführungsbeispiel wird die Ätzresistschicht 3 durch die stromlose Abscheidung von Zinn mit einer Stärke von beispielsweise 1 um erzeugt.

Nach der Abscheidung der Ätzresistschicht 3 wird diese gemäß Figur 3 auf der Oberseite im Bereich 400 der späteren Durchkontaktierungslöcher mittels elektromagnetischer Strahlung S wieder entfernt. Die in Figur 3 durch einen Pfeil angedeutete elektromagnetische Strahlung S wird im geschilderten Ausführungsbeispiel durch einen Nd:YAG-Laser erzeugt. Der Laserabtrag erfolgt dabei in einem Scanverfahren, wobei die Bereiche 400 des entsprechenden Lochbildes beispielsweise Durchmesser von 100 µm aufweisen.

Die gemäß Figur 3 durch selektiven Laserabtrag der Ätzresistschicht 3 freigelegten Bereiche der oberen Metallschicht 2 werden dann gemäß Figur 4 bis zur Oberfläche des Basismaterials 1 abgeätzt, wobei hierfür in der Subtraktivtechnik übliche Ätzlösungen eingesetzt werden können. Die beim Ätzvorgang in die Metallschicht 2 eingebrachten Löcher sind in Figur 3 durch einen mit 401 bezeichneten Bereich angedeutet.

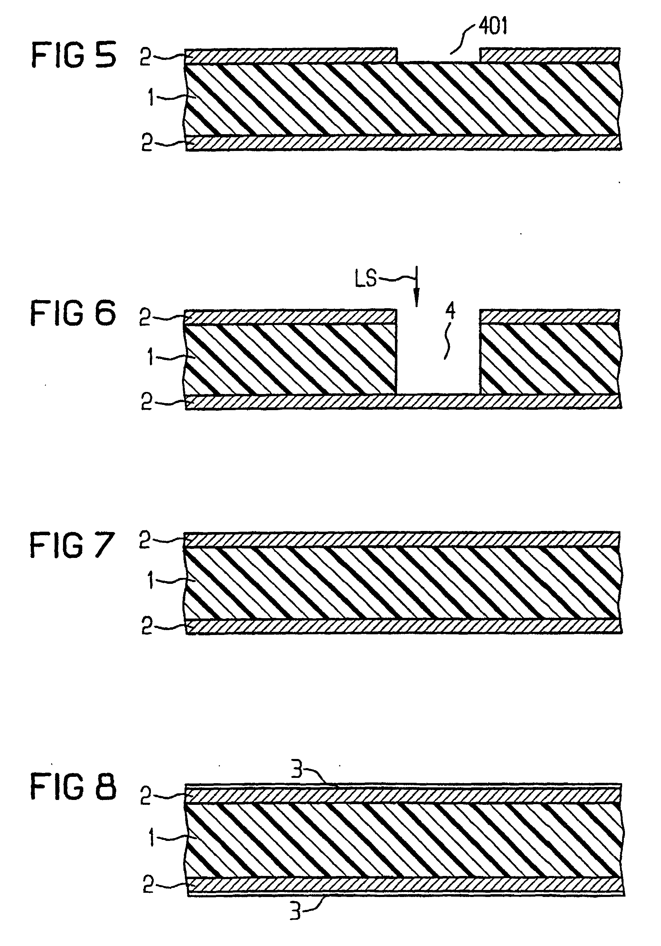

Gemäß Figur 5 wird die Ätzresistschicht 3 nach dem Strukturieren der oberen Metallschicht 2 vollständig gestrippt.

Nach dem Strippen der Ätzresistschicht 3 werden dann gemäß Figur 6 die mit 4 bezeichneten Durchkontaktierungslöcher in das Basismaterial 1 eingebracht. Im dargestellten Ausführungsbeispiel werden die als Sacklöcher ausgebildeten Durchkontaktierungslöcher 4 mit Hilfe von Laserstrahlen erzeugt, die in Figur 4 durch einen Pfeil LS angedeutet sind. Gemäß der aus der EP-A-0 164 564 bekannten Verfahrensweise wirkt dabei die obere strukturierte Metallschicht 2 als Maske, während die untere Metallschicht 2 den mit Hilfe eines Excimer-Lasers vorgenommenen Abtrag des Basismaterials beendet.

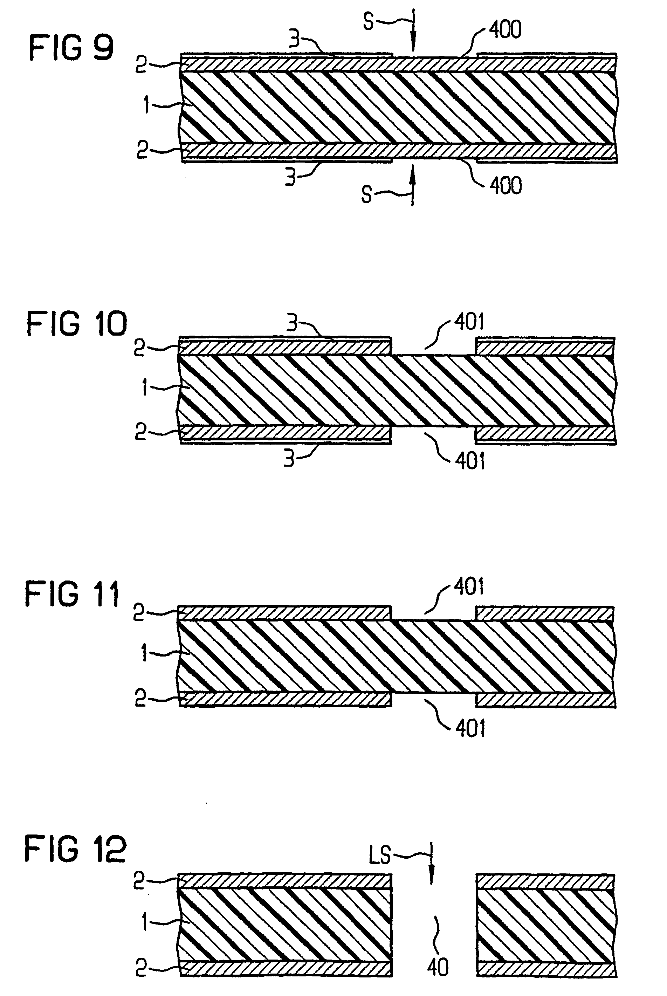

Bei der anhand der Figuren 7 bis 12 dargestellten Variante entsprechen die Figuren 7 und 8 den vorstehend bereits geschilderten Figuren 1 und 2.

Gemäß Figur 9 wird die Ätzresistschicht 3 sowohl auf der Oberseite als auch auf der Unterseite in den Bereichen 400 der späteren Durchkontaktierungslöcher mittels elektromagnetischer Strahlung S wieder entfernt. Die derart freigelegten Bereiche der Metallschichten 2 werden dann gemäß Figur 10 auf der Oberseite und der Unterseite bis zur Oberfläche des Basismaterials 1 abgeätzt.

Nach dem aus Figur 11 ersichtlichen Strippen der Ätzresistschicht 3 werden dann die gemäß Figur 12 als Durchgangslöcher ausgebildeten Durchkontaktierungslöcher 40 in das Basismaterial 1 eingebracht. Auch hier erfolgt der Abtrag des Basismaterials zur Bildung der Durchkontaktierungslöcher 40 wieder mit Hilfe von Laserstrahlung, die in Figur 12 durch einen Pfeil LS angedeutet ist.

## Patentansprüche

1. Verfahren zum Einbringen von Durchkontaktierungslöchern (4; 40) in ein beidseitig mit Metallschichten (2) versehenes, elektrisch isolierendes Basismaterial (1), mit folgenden Verfahrensschritten:
a) auf mindestens eine Metallschicht (2) wird eine Ätzresistschicht (3) aufgebracht;
b) die Ätzresistschicht (3) wird im Bereich der späteren Durchkontaktierungslöcher (4; 40)mit elektromagnetischer Strahlung (S) wieder entfernt;
c) die im Schritt b) freigelegten Bereiche der Metallschicht (2) werden bis zur Oberfläche des Basismaterials (1) weggeätzt;
d) die Durchkontaktierungslöcher (4; 40) werden mit Hilfe eines Laserstrahls (LS) in das Basismaterial (1) eingebracht, wobei die in den Verfahrensschritten a) bis c) strukturierte Metallschicht (2) als Maske für den Laserstrahl wirkt.

2. Verfahren nach Anspruch 1,
**dadurch gekennzeichnet,**
**dass** nach dem im Schritt c) vorgenommenen Ätzen die Ätzresistschicht (3) vollständig entfernt wird.

3. Verfahren nach Anspruch 1 oder 2,
**dadurch gekennzeichnet,**
**dass** von einem beidseitig kupferkaschierten Basismaterial (1) ausgegangen wird.

4. Verfahren nach einem der vorhergehenden Ansprüche,
**dadurch gekennzeichnet,**
**dass** eine metallische Ätzresistschicht (3) verwendet wird.

5. Verfahren nach Anspruch 4,
**dadurch gekennzeichnet,**
**dass** für die Ätzresistschicht (3) Zinn oder eine Zinn-Blei-Legierung verwendet wird.

6. Verfahren nach Anspruch 4 oder 5,
**dadurch gekennzeichnet,**
**dass** die Ätzresistschicht (3) durch stromlose Metallabscheidung aufgebracht wird.

7. Verfahren nach einem der Ansprüche 1 bis 3,
**dadurch gekennzeichnet,**
**dass** für die Ätzresistschicht (3) ein organisches Material verwendet wird.

8. Verfahren nach Anspruch 7,
**dadurch gekennzeichnet,**
**dass** die Ätzresistschicht (3) durch Elektrotauchlackierung oder durch elektrostatische Beschichtung aufgebracht wird.

9. Verfahren nach einem der vorhergehenden Ansprüche,
**dadurch gekennzeichnet,**
**dass** die elektromagnetische Strahlung (S) durch einen Laser erzeugt wird.

10. Verfahren nach Anspruch 9,
**dadurch gekennzeichnet,**
**dass** die Bewegung des Laserstrahls relativ zum Basismaterial (1) frei programmierbar ist.

11. Verfahren nach einem der vorhergehenden Ansprüche,
**dadurch gekennzeichnet,**
**dass** die Durchkontaktierungslöcher (4) im Schritt d) als durch eine Metallschicht (2) begrenzte Sacklöcher in das Basismaterial (1) eingebracht werden.

12. Verfahren nach einem der Ansprüche 1 bis 10,
**dadurch gekennzeichnet,**
**dass** die Durchkontaktierungslöcher (40) im Schritt d) als Durchgangslöcher in das Basismaterial (1) eingebracht werden.

## Claims

1. Method for introducing plated-through holes (4; 40) into an electrically insulating base material (1) that is provided with metal layers (2) on both sides, having the following method steps:
a) an etching resist layer (3) is applied to at least one metal layer (2);
b) the etching resist layer (3) is removed again in the region of the later plated-through holes (4; 40) using electromagnetic radiation (S);
c) those regions of the metal layer (2) which are uncovered in step b) are etched away as far as the surface of the base material (1);
d) the plated-through holes (4; 40) are introduced into the base material (1) with the aid of a laser beam (LS), the metal layer (2) structured in method steps a) to c) acting as a mask for the laser beam.

2. Method according to Claim 1,
**characterized**
**in that** after the etching performed in step c), the etching resist layer (3) is completely removed.

3. Method according to Claim 1 or 2,
**characterized**
**in that** the starting point is formed by a base material (1) that is coated with copper on both sides.

4. Method according to one of the preceding claims,
**characterized**
**in that** a metallic etching resist layer (3) is used.

5. Method according to Claim 4,
**characterized**
**in that** tin or a tin-lead alloy is used for the etching resist layer (3).

6. Method according to Claim 4 or 5,
**characterized**
**in that** the etching resist layer (3) is applied by electroless metal deposition.

7. Method according to one of Claims 1 to 3,
**characterized**
**in that** an organic material is used for the etching resist layer (3).

8. Method according to Claim 7,
**characterized**
**in that** the etching resist layer (3) is applied by electro-dipcoating or by electrostatic coating.

9. Method according to one of the preceding claims,
**characterized**
**in that** the electromagnetic radiation (S) is generated by a laser.

10. Method according to Claim 9,
**characterized**
**in that** the movement of the laser beam relative to the base material (1) is freely programmable.

11. Method according to one of the preceding claims,
**characterized**
**in that**, in step d), the plated-through holes (4) are introduced into the base material (1) as blind holes bounded by a metal layer (2).

12. Method according to one of Claims 1 to 10,
**characterized**
**in that**, in step d), the plated-through holes (40) are introduced into the base material (1) as through holes.

## Revendications

1. Procédé pour introduire des trous de connexion (4 ; 40) dans un matériau de base (1) électro-isolant muni de part et d'autre de couches de métal (2), comprenant les étapes suivantes :
a) sur au moins une couche de métal (2) est déposée une couche résist (3);
b) la couche résist (3) est enlevée à nouveau par rayonnement électromagnétique (S) dans la région où seront réalisés les trous de connexion (4 ; 40) ;
c) les régions dégagées dans l'étape b) de la couche de métal (2) sont gravées jusqu'à la surface du matériau de base (1) ;
d) les trous de connexion (4 ; 40) sont introduits au moyen d'un faisceau laser (LS) dans le matériau de base (1), la couche de métal (2) structurée dans les étapes a) à c) agissant comme masque pour le faisceau laser.

2. Procédé selon la revendication 1, **caractérisé en ce que** la couche résist (3) est entièrement enlevée après la gravure pratiquée dans l'étape c).

3. Procédé selon la revendication 1 ou 2, **caractérisé en ce qu'**on part d'un matériau de base (1) revêtu de part et d'autre de cuivre.

4. Procédé selon l'une des revendications précédentes, **caractérisé en ce qu'**on utilise une couche résist (3) de métal.

5. Procédé selon la revendication 4, **caractérisé en ce qu'**on utilise pour la couche résist (3) de l'étain ou un alliage étain/plomb.

6. Procédé selon la revendication 4 ou 5, **caractérisé en ce qu'**on applique la couche résist (3) par dépôt de métal sans courant.

7. Procédé selon l'une des revendications 1 à 3, **caractérisé en ce qu'**on utilise un matériau organique pour la couche résist (3).

8. Procédé selon la revendication 7, **caractérisé en ce que** la couche résist (3) est appliquée par vernissage électrique à immersion ou par revêtement électrostatique.

9. Procédé selon l'une des revendications précédentes, **caractérisé en ce que** le rayonnement électromagnétique (S) est obtenu par un laser.

10. Procédé selon la revendication 9, **caractérisé en ce que** le mouvement du faisceau laser par rapport au matériau de base (1) est librement programmable.

11. Procédé selon l'une des revendications précédentes, **caractérisé en ce que** les trous de connexion (4) sont introduits dans l'étape d) sous forme de trous borgnes limités par une couche de métal (2) dans le matériau de base (1).

12. Procédé selon l'une des revendications 1 à 10, **caractérisé en ce que** les trous de connexion (40) sont introduits dans l'étape d) sous forme de trous de passage dans le matériau de base (1).
